# EUROPEAN PATENT SPECIFICATION

(11) **EP 0 388 563 B1**
(45) Date of publication and mention of the grant of the patent: **14.12.1994**
(21) Application number: 89400828.3
(22) Date of filing: 24.03.1989
(51) Int. Cl.: H01L 21/60, H01L 21/90, H01L 21/321

(54) **Method for forming a contact/VIA**
Verfahren zum Herstellen eines Kontaktes/VIA
Procédé de fabrication d'un contact/via

(43) Date of publication of application: 26.09.1990
(73) Proprietor: SGS-THOMSON MICROELECTRONICS, INC. (a Delaware corp.), Carrollton, TX 75006 (US)
(72) Inventor: Liou, Fu-Tai, F-75116 Paris (FR); Miller, Robert Otis, F-75116 Paris (FR); Farahani, Mohammed M., F-75116 Paris (FR); Han, Yu-Pin, F-75116 Paris (FR)
(74) Representative: Driver, Virginia Rozanne

(56) References cited:
- EP-A- 0 075 085
- EP-A- 0 279 588
- EP-A- 0 284 794
- WO-A-86/01639
- EXTENDED ABSTRACTS, SPRING MEETING, vol. 88-1, 15th-20th May 1988, page 126,abstract nr. 87, Princeton, NY, US; B. COHEN et al.: "Rapid thermal precessing of TIN and TISI 2 films for VLSI applications"
- Solid State Technology. 27(1984) Aug. no. 8 pgs 145-149

## Description

The present invention pertains in general to contacts and VIAs utilized in a semiconductor process, and, more particularly, to improving the step coverage of the contacts and VIAs.

In semiconductor processing, one of the more critical process steps is the interconnection of two conducting layers on different levels that are separated by an insulating layer, especially when one of the conductive layers is the top metal layer. Presently, an underlying conductor layer is covered with an interlevel oxide layer and then the contact or VIA formed therein to expose the surface of the underlying conductor layer at a selected area. A top conducting layer is then patterned and interconnected through the contact or VIA with the underlying conducting material. This underlying conducting material can comprise either a conductive layer of polysilicon or metal or even the silicon surface itself.

To realize a conductive interconnection between the two layers, it is important that the contact interface between the underlying metal or silicon presents a low resistance without altering the characteristics of the underlying material, especially when the material is silicon. Further, it is important that the resistance between the contact interface itself and the upper metal layer also presents a low resistance.

One disadvantage with past processing techniques is "voiding" of the upper metal layer on the vertical surfaces of the contact opening or VIA. This can result from a number of factors. One factor which is prominent in the industry is that when sputtering or physical vapor deposition techniques are utilized to deposit a metal layer, the coverage is not conformal. Since this is an anisotropic process, vertical surfaces in a contact opening or VIA have only a relatively thin layer of metal formed on the vertical walls with a thick "build up" along the upper edges of the contact opening or VIA. The voiding typically occurs along these vertical surfaces. This can be solved by utilizing chemical vapor deposition of a conductive material. However, chemical vapor deposition processes are normally not suited to the types of metal, etc., that are required for upper levels, such as for aluminum metalization processes.
Reference is made to the following documents.

The document WO 86/01639 discloses a contact structure formed in an opening in a dielectric layer. A smoothing region is deposited on sidewalls of the opening to obtain better conductor coverage. A conductive interconnect material is then deposited directly over the smoothing region.

The article "Refratory Metals and Metal Silicides for VLSI devices" by Chen and Roth, in Solid State Technology 27 (1984) Aug. No. 8, pages 145-149, discusses the use of refractory metals and the formation of a single refractory metal layer in contacts and interconnects.

The document EP-A-284794 discloses a conductive structure used for interconnections, consisting of a thick layer of a refractory metal overlying a thin layer of titanium nitride.

The document EP-A-279588 discloses a contact structure in a contact hole, comprising a thin layer of titanium, a barrier layer of refractory metal or refractory metal nitride, and a conductive material filling the contact hole.

According to one aspect of the present invention, there is provided a method for forming a contact for a semiconductor integrated circuit device, comprising the steps of:
forming an insulating layer over a conductive silicon region;
forming an opening in the insulating layer to expose a portion of the conductive silicon region, such opening having substantially vertical sidewalls;
forming a conformal insulating layer over the insulating layer and in the opening;
anisotropically etching the conformal insulating layer to form sidewall spacer regions along the vertical sidewall openings and to expose the conductive silicon region, such sidewall spacer regions having a greater thickness adjacent the conductive silicon region than at an upper surface of the insulating layer;
forming a layer of refractory metal over the insulating layer, the sidewall spacer regions, and the exposed conductive silicon region;
heating the device in a nitrogen ambient atmosphere, wherein a portion of the refractory metal layer is converted to refractory metal silicide on the exposed conductive silicon region, and the remainder of the refractory metal layer is converted to refractory metal nitride;
forming a conformal conducting layer containing refractory metal over the refractory metal nitride; and
forming an aluminum layer over the conformal conducting layer.

Embodiments of the present invention comprise a method for forming a contact between two conductive layers on different levels. A silicon substrate or first conductive layer forms a lower level of conductive material. This layer is covered by a layer of interlevel oxide. An opening is formed through the layer of interlevel oxide and then a conformal layer of refractory material is deposited over the structure to cover the side walls of the opening to a uniform thickness. This provides conduction between both levels separated by the interlevel oxide layer. A metal layer is then sputtered on the upper surface to provide an interconnection between the upper portion of the layer of refractory material and other structures on the upper level.

The refractory material is deposited over the entire substrate extending over the surface of the interlevel oxide and the bottom surface of the opening adjacent the lower level. A barrier metal is disposed between the conformal layer of refractory material and the lower conductive level.

A sidewall oxide layer is formed on the sidewalls of the opening with a tapered profile. The tapered profile extends from a narrow portion at the upper level to a wider portion at the lower level, such that the opening at the upper level is larger. This provides a more graduated step over which the conformal layer of refractory material is formed. The refractory material in the preferred embodiment is tungsten disilicide.

According to another aspect of the present invention, there is provided, in an integrated circuit, a structure for connecting a first level silicon conductor and a second level metal conductor separated by an insulating layer, comprising:
an opening having substantially vertical sidewalls and extending through the insulating layer, wherein a portion of the first level conductor is exposed in the opening;
insulating material sidewall spacer regions covering the sidewalls of the opening, such sidewall spacer regions having a greater thickness adjacent the first level silicon conductor than at an upper surface of the insulating layer;
a refractory metal silicide layer covering the exposed portion of the first level silicon conductor;
a refractory metal nitride layer covering the refractory metal silicide layer, the sidewall spacer regions and a portion of the upper surface of the insulating layer; and
a conformal conducting layer containing refractory metal covering the refractory metal nitride layer; wherein
said second level metal conductor comprises an aluminium layer covering the conformal conducting layer.

For a more complete understanding of the present invention and the advantages thereof, reference is now made to the following description taken in conjunction with the accompanying Drawings in which:
FIGURE 1 illustrates a cross sectional diagram of a silicon substrate or metal layer with an oxide layer formed thereon and having a contact/VIA formed therethrough;
FIGURE 2 illustrates the structure of FIGURE 1 with a thin layer of oxide formed thereover;
FIGURE 3 illustrates a cross-sectional diagram of the structure of FIGURE 2 with the upper layer of the oxide etched away to form a sidewall oxide in the contact/VIA;
FIGURE 4 illustrates the structure of FIGURE 3 with a thin layer of refractory metal formed thereon;
FIGURE 5 illustrates a cross-sectional diagram of the structure of FIGURE 4 with the refractory metal converted to a barrier layer of refractory material;
FIGURE 6 illustrates a cross-sectional diagram of the structure of FIGURE 5 with a layer of CVD refractory material formed over the barrier layer;
FIGURES 6a and 6b illustrate an alternate method for forming the CVD layer of refractory material of FIGURE 6 wherein a layer of refractory metals is first formed over the structure of FIGURE 5 followed by a layer of polycrystalline silicon to form a silicide layer; and
FIGURE 7 illustrates a cross-sectional view of the structure of FIGURE 6 with a layer of metal formed over the substrate, which layer was sputtered on by physical vapor deposition techniques.

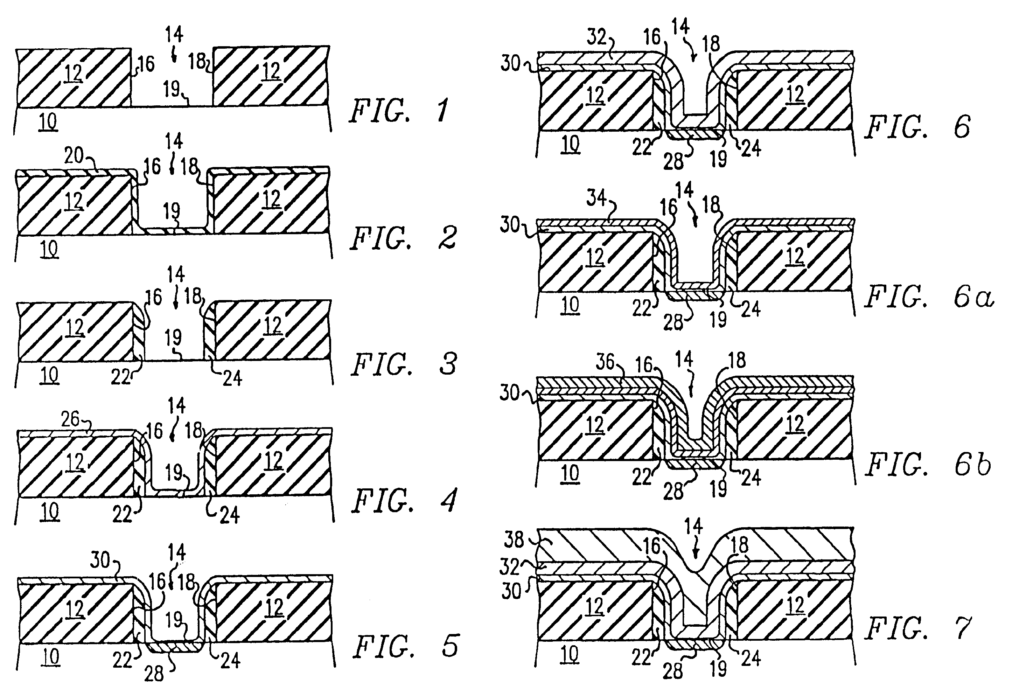

Referring now to FIGURE 1, there is illustrated a cross-sectional diagram of a semiconductor structure 10 with an interlevel oxide 12 formed thereover. The semiconductor structure 10, in the preferred embodiment, is silicon. However, for the purposes of describing the invention, the structure 10 could represent a first-level of conductor, as will be described in more detail herein below.

The oxide layer 12 is normally referred to as an interlevel oxide which is an oxide having a thickness of approximately 5,000-10,000 Å. (10Å = 1nm) After formation of the oxide-layer 12, a contact or VIA 14 is formed in the oxide layer 12 which will hereinafter be referred to as VIA 14. As viewed in cross- section, the VIA 14 has two vertical sidewalls 16 and 18, and is formed by patterning the surface of the oxide layer 12 with a photoresist operation and then subjecting the structure to an anisotropic plasma etch, which etches away oxide in the unmasked areas, thus forming the vertical sidewalls 16 and 18.

After formation of the VIA 14, a conformal layer of insulating material 20 is then deposited over the VIA 14 and the oxide layer 12 to conformally coat the vertical sidewalls 16 and 18 and the bottom surface of the contact/VIA 19. The insulating layer 20 may advantageously comprise deposited silicon oxide or nitride. This may be deposited by a conventional or low-temperature reaction process using chemical vapor deposition techniques. The layer 20 may be formed several thousand angstroms in thickness; preferably, is formed at a thickness of 2,000 Å. As described above, the layer 20 conforms to the geometry of the VIA 14 and adheres to the vertical walls or sidewalls 16 and 18.

As illustrated in FIGURE 3, the insulating layer 20 is anisotropically removed resulting in a structure wherein the sidewalls 16 and 18 are covered by relatively thick sidewall oxide layers 22 and 24, respectively. By way of illustration, if the thickness of the insulated layer 20 were 2,000 Å, the lateral thickness of the sidewall oxides 22 and 24 would be approximately 2,000 Å proximate to the bottom surface 19 and slightly thinner proximate the upper surface of the oxide layer 20. Therefore, the sidewall oxide layers 22 and 24 will have a tapered surface rather than a vertical surface. As will be described hereinbelow, this will present a "rounded" surface to the formation of conductive layers in the VIA 14.

The insulating layer 20 may be anisotropically removed by various techniques; preferably an etch is used which preferentially etches the insulating layer 20 in only the vertical direction without significant undercutting or lateral etch. The formation of sidewall oxides is utilized widely in the industry for a number of purposes. One purpose is to seal the sidewalls on various conductive structures such as the gates of MOS transistors or to provide a spacer from a vertical wall for implantation techniques. A process for forming sidewall oxides is described in detail in U.S. Patent No. 4,356,040, issued to Horng-Sen Fu, et. al., on October 26, 1982, which U.S. Patent is incorporated herein by reference.

After formation of the sidewall oxide layers 22 and 24, a thin layer of refractory metal 26 is sputtered onto the substrate to thickness of approximately 500 Å. In the preferred embodiment, the refractory metal utilized is titanium. The titanium is then subjected to a Rapid Thermal Anneal (RTA) in an atmosphere of nitrogen or NH₃ which results in the formation of a layer of titanium silicide (TiSi₂) 28 formed at or beneath the surface of the silicon substrate 10 proximate to the bottom 19 of the VIA 14 and a layer of titanium nitride (TᵢN) 30 over the remaining portions of the VIA 14, outer surfaces of the sidewall layers 22 and 24 and the upper surfaces of the oxide layer 12. It will be appreciated that some portion of the titanium layer 26 consumes silicon to form the silicide layer 28 and the nitrogen reacts with the titanium to form the titanium nitride. When the titanium in the titanium layer 26 is reacted in the nitrogen atmosphere to form titanium disilicide, the process results in two competing reactions occurring over silicon. The first reaction is the formation of titanium nitride which grows downward from the gas phase as in conjunction with a second reaction to form titanium silicide which grows upward from the silicon interface. Since these competing reactions have unequal activation energies, the TiN/TiSi₂ thickness ratio is a sensitive function of temperature. However, the result is that there is a formation of some predetermined amount of TiN overlying the silicon in the titanium nitride layer 30 which is thinner than the remaining portions of the titanium nitride layer 30 overlying the oxide. Both the titanium silicide layer 28 and titanium nitride layer 30 are very conductive materials with the portion of the titanium nitride layer 30 and the titanium silicide layer 28 proximate to the bottom 19 of the VIA 14 forming a barrier metal. The formation of the layers 28 and 30 is illustrated in FIGURE 5. It should be noted that if a lower level conductor is present at the bottom 19 of the VIA 14 and the lower level conductor does not comprise or contain silicon, the titanium silicide layer 28 will not form. The purpose of the titanium nitride layer 30 is to provide a barrier to any interaction between later formed layers and underlying material such as the silicon. However, if the underlying layer is a metal such as Aluminum, TiN should be directly sputtered on the surface of the Aluminum, instead of the step of RTA of Ti. For example, if a metal were deposited directly on the silicon, some "spiking" or "tunneling" may occur, which phenomena are well known in the industry.

After formation of the barrier titanium nitride layer 30 on the bottom surface 19 of the VIA 14, a conformal conductive layer 32 is formed over the titanium nitride layer 30 to a thickness of approximately 2,000 Å. Typically, to form a conformal layer, a chemical vapor deposition technique (CVD) is utilized. In the present embodiment, tungsten disilicide (WSi₂) is deposited by CVD deposition. Of the various silicides, WSi₂ is the only one at present that can conveniently be deposited by CVD deposition to provide a conformal layer. By contrast, sputtering materials such as aluminum to provide the conductive layer requires the use of a physical vapor deposition process. Typically, this is an anisotropic process which results in poor coverage on vertical or near vertical surfaces. Therefore, it is an important aspect of the present invention that a process is utilized that will result in a highly conductive layer formed on the sidewall in VIA 14. As will be described in more detail hereinbelow, the important portion of the conformal layer 32 with respect to its conductivity is the portion thereof that is adjacent to the outer surface of the sidewall oxide layers 22 and 24 and separated therefrom by the titanium nitride layer 30. This provides the conductive step. It is important to note that the conformal nature of the layer 32 and the step coverage provided thereby is enhanced by the use of the sidewall oxide layers 22 and 24 which operate as a "tapered spacer".

Although the preferred embodiment utilizes direct deposition of WSi₂ by CVD techniques, it should be understood that various techniques can be utilized to deposit a highly conductive layer. For example, polycrystalline silicon could be utilized, which is suitable for CVD processes, but its sheet resistance is relatively high, thus degrading the conductive nature of the conductor. Another technique that can be utilized is illustrated with respect to FIGUREs 6a and 6b. In FIGURE 6a, a layer 34 titanium is sputtered onto the substrate to a thickness of approximately 800 Å in a vacuum at a temperature of approximately 100°C. This is then followed by a layer 36 of doped or undoped polycrystalline silicon that is deposited by CVD techniques to a thickness of approximately 1,500 Å. The substrate is then subjected to an RTA at approximately 950°C for approximately thirty seconds to form a titanium silicide. The titanium silicide region is approximately 2,000 - 3,000 Å thick. Although titanium silicide is utilized in the present embodiment, it should be understood that any silicide such as MoSi₂, WSi₂ or TaSi₂ could be utilized. After reaction to form the titanium silicide, the conductive layer 32 would therefore be formed of titanium silicide rather than tungsten silicide. It should be understood that the disadvantages caused by the non-conformality of physical vapor deposited films apply mainly to thick films. This situation is mitigated to some degree by the physical vapor deposition of a thin film (e.g., Ti) and then building on it with a CVD film (e.g., poly).

Referring now to FIGURE 7, after formation of the conductive layer 32, a layer 38 of metal is sputtered over the layer 32. In the preferred embodiment, the metal layer 38 is aluminum which is sputtered on to a thickness of approximately 5,000-8,000 Å. The aluminum layer 38 can be seen to have a relatively constant thickness in the portions that overlie the oxide layer 12. However, the portion overlying the VIA 14 is variable in thickness. This thickness is due to the anisotropic nature of the sputtering process. Although illustrated as a continuous coverage in VIA 14, there is still a possibility that voids can appear. The probability of voids is somewhat diminished due to the presence of the layers 22 and 24 which provide a tapered surface and the conformal layer 32 which also provides somewhat of a tapered surface rather than a sharp edge or step. However, it is not important whether there is a sharp edge or step presented to the aluminum layer 38, since the conductive connection to the bottom 19 of the VIA 14 is provided by the conformal layer 30 of titanium nitride and conformal layer 32 of WSi₂. As described above, for purposes of interconnection of the metal layer 38 with the surface of the silicon, or in the case of an underlying conductive layer, the underlying conductor, the only portion of the conformal layers 30 and 32 that provides the necessary conductive interconnection are the portions extending from the upper level to the lower level. It is therefore only necessary that these portions exist for providing a reliable interconnection between the metal layer 38 and the bottom surface 19 of the VIA 14.

Although the horizontal surfaces of the conformal layers 30 and 32 of titanium nitride and WSi₂ do not function primarily to provide a conductive interconnection between the metal layer 38 and the bottom surface 19 of the VIA 14, they do otherwise, or in any case provide for a better electromigration resistant metal system.

In summary, there has been provided a process for improving step coverage and reliability of a VIA/contact opening. The process utilizes a sidewall oxide spacer formed on the vertical walls of the VIA/contact opening followed by formation of a barrier metal layer on the bottom surface of the VIA/contact opening. A conformal layer of refractory material such as a silicide, is then deposited over the structure to conformally cover the surfaces of the VIA/contact opening including the outer surfaces of the sidewall spacers. The sidewall spacers provide a tapered surface that extends at an angle with respect to the bottom surface of VIA/contact opening. A metal layer is then sputtered onto the conformal layer with the conformal layer providing a conductive interconnection between the upper level and the lower level such that any step coverage problems with respect to the sputtering process are overcome.

## Claims

1. A method for forming a contact for a semiconductor integrated circuit device, comprising the steps of:
forming an insulating layer (12) over a conductive silicon region (10);
forming an opening (14) in the insulating layer to expose a portion (19) of the conductive silicon region, such opening having substantially vertical sidewalls (16,18);
forming a conformal insulating layer (20) over the insulating layer and in the opening;
anisotropically etching the conformal insulating layer to form sidewall spacer regions (22,24) along the vertical sidewall openings and to expose the conductive silicon region, such sidewall spacer regions having a greater thickness adjacent the conductive silicon region than at an upper surface of the insulating layer;
forming a layer of refractory metal (26) over the insulating layer, the sidewall spacer regions, and the exposed conductive silicon region;
heating the device in a nitrogen ambient atmosphere, wherein a portion of the refractory metal layer is converted to refractory metal silicide (28) on the exposed conductive silicon region, and the remainder of the refractory metal layer is converted to refractory metal nitride (30);
forming a conformal conducting layer (32) containing refractory metal over the refractory metal nitride; and
forming an aluminum layer (38) over the conformal conducting layer.

2. A method as claimed in Claim 1, further comprising the step of:
after said step of forming an aluminum layer (38), patterning the aluminum layer to define interconnect.

3. A method as claimed in Claim 1 or 2, wherein said step of forming a conformal conducting layer (32) comprises the step of:
depositing tungsten silicide over the refractory metal nitride (30) using chemical vapor deposition.

4. A method as claimed in Claim 1 or 2, wherein said step of forming a conformal conducting layer comprises the steps of:
depositing a second refractory metal layer (34) over the refractory metal nitride (30);
depositing a polycrystalline silicon layer (36) over the second refractory metal layer; and
heating the device to convert the polycrystalline silicon and second refractory metal layers into a refractory metal silicide layer (32).

5. A method as claimed in any preceding claim, wherein the layer of refractory metal (26) is a layer of titanium.

6. A method as claimed in claim 4, wherein the second refractory metal layer (34) comprises titanium.

7. A method as claimed in any preceding claim, wherein the conformal conducting layer of refractory metal has a substantially uniform thickness.

8. A method as claimed in any preceding claim, wherein the refractory metal silicide (28) is titanium silicide.

9. A method as claimed in any preceding claim, wherein the refractory metal nitride (30) is titanium.

10. A method as claimed in any preceding claim, wherein the aluminium layer (38) overlies said conformal conducting layer (32) above the insulating layer, wherein a conductive connection is made from the conductive silicon region (10) through said refractory metal silicide layer (28), through said refractory metal nitride layer (30) and through said conformal conductor layer, to said aluminium layer (38).

11. In an integrated circuit, a structure for connecting a first level silicon conductor (10) and a second level metal conductor (38) separated by an insulating layer (12), comprising:
an opening (14) having substantially vertical sidewalls (16,18) and extending through the insulating layer, wherein a portion (19) of the first level conductor is exposed in the opening;
insulating sidewall spacer regions (22,24) covering the sidewalls of the opening, such sidewall spacer regions having a greater thickness adjacent the first level silicon conductor than at an upper surface of the insulating layer;
a refractory metal silicide layer (28) covering the exposed portion of the first level silicon conductor;
a refractory metal nitride layer (30) covering the refractory metal silicide layer, the sidewall spacer regions and a portion of the upper surface of the insulating layer; and
a conformal conducting layer (32) containing refractory metal covering the refractory metal nitride layer (30); wherein
said second level metal conductor comprises an aluminium layer covering the conformal conducting layer.

12. A structure as claimed in claim 11, wherein the conformal conducting layer (32) comprises a refractory metal silicide.

13. A structure as claimed in claim 12, wherein the conformal conducting layer (32) comprises tungsten disilicide.

14. A structure as claimed in claim 12, wherein the conformal conducting layer (32) comprises titanium silicide.

15. A structure as claimed in any one of claims 11 to 14, wherein said refractory metal silicide layer (28) comprises titanium silicide.

16. A structure as claimed in any one of claims 11 to 15, wherein said refractory metal nitride layer (30) comprises titanium nitride.

17. A structure as claimed in claim 11, wherein the second level conductor (38) overlies said conformal conducting layer (32) above the insulating layer (12), wherein a conducting connection is made from the first level conductor through said refractory metal silicide layer (28), through said refractory metal nitride layer (30), and through said conformal conductor layer, to said second level conductor.

18. A structure as claimed in one of claims 11 - 17, wherein the conformal conducting layer (32) comprising a refractory metal silicide has a substantially uniform thickness.

## Patentansprüche

1. Verfahren zur Herstellung eines Kontaktes für eine integrierte Halbleiterschaltvorrichtung mit folgenden Schritten:
über einer leitfähigen Siliciumschicht (10) wird eine Isolierschicht (12) ausgebildet;
in der Isolierschicht wird eine Öffnung (14) gebildet, um einen Teil (19) des leitfähigen Siliciumbereichs freizulegen, wobei diese Öffnung im wesentlichen senkrechte Seitenwände (16, 18) aufweist;
eine konforme Isolierschicht (20) wird über der Isolierschicht und der Öffnung ausgebildet;
die konforme Isolierschicht wird anisotrop geätzt, um Seitenwandabstandsbereiche (22, 24) entlang der senkrechten Öffnungen der Seitenwand zu bilden und den leitfähigen Siliciumbereich freizulegen, wobei die Seitenwandabstandsbereiche unmittelbar neben dem leitfähigen Siliciumbereich dicker sind als an einer oberen Fläche der Isolierschicht;
eine Schicht aus hochschmelzendem Metall (26) wird über der Isolierschicht, den Abstandsbereichen der Seitenwände und dem freiliegenden leitfähigen Siliciumbereich ausgebildet;
die Vorrichtung wird in einer Stickstoffumgebungsatmosphäre erhitzt, wobei ein Teil der hochschmelzenden Metallschicht auf dem freiliegenden leitfähigen Siliciumbereich zu hochschmelzendem Metallsilicid (28) und der Rest der hochschmelzenden Metallschicht zu hochschmelzendem Metallnitrid (30) umgewandelt wird;
eine konforme Leiterschicht (32) wird ausgebildet, die hochschmelzendes Metall über dem hochschmelzenden Metallnitrid enthält; und
eine Aluminiumschicht wird (38) über der konformen Leiterschicht ausgebildet.

2. Verfahren nach Anspruch 1, das zusätzlich den Schritt enthält, daß nach dem Schritt der Ausbildung einer Aluminiumschicht (38) diese mit einem Muster versehen wird, um die Zwischenschaltung bzw. Zwischenanschlüsse zu definieren.

3. Verfahren nach Anspruch 1 oder 2, bei dem der Schritt zur Ausbildung der konformen Leiterschicht (32) den Schritt enthält, Wolframsilicid über dem hochschmelzenden Metallnitrid (30) abzuscheiden, wobei ein Chemical-Vapour-Deposition-Verfahren verwendet wird.

4. Verfahren nach Anspruch 1 oder 2, bei dem der Schritt zur Ausbildung einer konformen Leiterschicht die folgenden Schritte enthält:
über dem hochschmelzenden Metallnitrid (30) wird eine zweite hochschmelzende Metallschicht (34) abgeschieden und
über der zweiten hochschmelzenden Metallschicht wird eine polykristalline Siliciumschicht (36) abgeschieden und
zur Umwandlung der Schicht aus polykristallinem Silicon und der zweiten hochschmelzenden Metallschicht zu einer hochschmelzenden Metallsilicidschicht (32) wird die Vorrichtung erhitzt.

5. Verfahren nach einem der vorstehenden Ansprüche, bei dem die Schicht aus hochschmelzendem Metall (26) aus Titan besteht.

6. Verfahren nach Anspruch 4, bei dem die zweite hochschmelzende Metallschicht (34) Titan umfaßt.

7. Verfahren nach einem der vorstehenden Ansprüche, bei dem die konforme Leiterschicht aus hochschmelzendem Metall eine im wesentlichen einheitliche Dicke aufweist.

8. Verfahren nach einem der vorstehenden Ansprüche, bei dem das hochschmelzende Metallsilicid (28) Titansilicid ist.

9. Verfahren nach einem der vorstehenden Ansprüche, bei dem das hochschmelzende Metallnitrid (30) Titan ist.

10. Verfahren nach einem der vorstehenden Ansprüche, bei dem die Aluminiumschicht (38) über der konformen Leiterschicht (32) oberhalb der Isolierschicht liegt und bei dem eine leitfähige Verbindung vom leitfähigen Siliciumbereich (10) durch die hochschmelzende Metallsilicidschicht (28), die hochschmelzende Metallnitridschicht (30) und die konforme Leiterschicht zur Aluminiumschicht (38) hergestellt wird.

11. Integrierte Schaltung mit einer Struktur zur Verbindung eines Siliciumleiters (10) eines ersten Niveaus und eines Metalleiters (38) eines zweiten Niveaus, die durch eine Isolierschicht (12) getrennt sind,
mit einer Öffnung (14) mit im wesentlichen senkrechten Seitenwänden (16, 18), die durch die Isolierschicht reicht, wobei ein Teil (19) des Leiters des ersten Niveaus in der Öffnung freiliegt;
mit isolierenden Seitenwandabstandsbereichen (22, 24), die die Seitenwände der Öffnung bedecken und benachbart zu dem Siliciumleiter des ersten Niveaus dicker sind als an der oberen Oberfläche der Isolierschicht;
mit einer hochschmelzenden Metallsilicidschicht (28), die den freigelegten Teil der Siliciumleiters des ersten Niveaus bedeckt;
mit einer hochschmelzenden Metallnitridschicht (30), die die hochschmelzende Metallsilicidschicht, die Seitenwandabstandsbereiche und einen Teil der oberen Oberfläche der Isolierschicht bedeckt, und
mit einer konformen Leiterschicht (32), die hochschmelzendes Metall enthält und die hochschmelzende Metallnitridschicht (30) bedeckt,
wobei der Metalleiter des zweiten Niveaus eine Aluminiumschicht aufweist, die die konforme Leiterschicht bedeckt.

12. Struktur nach Anspruch 11, bei der die konforme Leiterschicht (32) ein hochschmelzendes Metallsilicid umfaßt.

13. Struktur nach Anspruch 12, bei der die konforme Leiterschicht (32) Wolframdisilicid umfaßt.

14. Struktur nach Anspruch 12, bei der die konforme Leiterschicht (32) Titansilicid umfaßt.

15. Struktur nach einem der Ansprüche 11 bis 14, bei der die hochschmelzende Metallsilicidschicht (28) Titansilicid umfaßt.

16. Struktur nach einem der Ansprüche 1 bis 15, bei der die hochschmelzende Metallnitridschicht (30) Titannitrid umfaßt.

17. Struktur nach Anspruch 11, bei der der Leiter (38) des zweiten Niveaus über der konformen Leiterschicht (32) oberhalb der Isolierschicht (12) liegt und bei der eine leitende Verbindung zwischen dem Leiter des ersten Niveaus durch die hochschmelzende Metallsilicidschicht (28), die hochschmelzende Metallnitridschicht (30) und die konforme Leiterschicht zum Leiter des zweiten Niveaus hergestellt wird.

18. Struktur nach Anspruch 11 bis 17, bei der die ein hochschmelzendes Metall enthaltende konforme Leiterschicht (32) eine im wesentlichen einheitliche Dicke aufweist.

## Revendications

1. Procédé pour former un contact pour un dispositif de circuit intégré à semi-conducteur, comprenant les étapes consistant à :
former une couche (12) isolante sur une zone (10) de silicium conductrice;
former une ouverture (14) dans la couche isolante pour exposer une partie (19) de la zone de silicium conductrice, laquelle ouverture ayant des parois latérales (16, 18) sensiblement verticales ;
former une couche (20) isolante conforme qui épouse la forme de la couche isolante et de l'ouverture ;
attaquer chimiquement, de manière anisotropique, la couche isolante conforme pour constituer des zones (22, 24) d'écartement de parois latérales le long des ouvertures de parois latérales verticales et pour exposer la zone de silicium conductrice, les zones d'écartement de parois latérales ayant une plus grande épaisseur à proximité immédiate de la zone de silicium conductrice qu'au niveau d'une surface supérieure de la couche isolante ;
former une couche (26) de métal réfractaire sur la couche isolante, les zones d'écartement de parois latérales et la zone de silicium conductrice exposée ;
chauffer le dispositif dans une atmosphère ambiante d'azote, une partie de la couche de métal réfractaire étant convertie en un siliciure métallique réfractaire (28) sur la zone de silicium conductrice exposée, et le restant de la couche de métal réfractaire étant convertie en un nitrure métallique réfractaire (30) ;
former une couche (32) conductrice conforme, contenant un métal réfractaire, sur le nitrure métallique réfractaire ; et
former une couche (38) d'aluminium sur la couche conductrice conforme.

2. Procd selon la revendication 1, comprenant en outre une tape consistant :
aprs ladite tape de formation d'une couche (38) d'aluminium, former un motif dans la couche d'aluminium pour dfinir une interconnexion.

3. Procd selon la revendication 1 ou 2, dans lequel ladite tape de formation d'une couche (32) conductrice conforme comprend l'tape consistant :
dposer du siliciure de tungstne sur le nitrure mtallique rfractaire (30) au moyen d'un dpt chimique en phase vapeur.

4. Procd selon la revendication 1 ou 2, dans lequel ladite tape de formation d'une couche conductrice conforme comprend les tapes consistant :
dposer une seconde couche (34) de mtal rfractaire sur le nitrure mtallique rfractaire (30) ;
dposer une couche (36) de silicium polycristallin sur la seconde couche de mtal rfractaire ; et
chauffer le dispositif pour convertir la couche de silicium polycristallin et la seconde couche de métal réfractaire en une couche (32) de siliciure métallique réfractaire.

5. Procédé selon l'une quelconque des revendications précédentes, dans lequel la couche (26) de métal réfractaire est une couche de titane.

6. Procédé selon la revendication 4, dans lequel la seconde couche (34) de métal réfractaire comprend du titane.

7. Procédé selon l'une quelconque des revendications précédentes, dans lequel la couche conductrice conforme en métal réfractaire a une épaisseur sensiblement uniforme.

8. Procédé selon l'une quelconque des revendications précédentes, dans lequel le siliciure métallique réfractaire (28) est du siliciure de titane.

9. Procédé selon l'une quelconque des revendications précédentes, dans lequel le nitrure métallique réfractaire (30) est du titane.

10. Procédé selon l'une quelconque des revendications précédentes, dans lequel la couche (38) d'aluminium est sus-jacente à ladite couche (32) conductrice conforme située au-dessus de la couche isolante, et en ce qu'une connexion conductrice est faite à partir de la zone (10) de silicium conductrice, en traversant ladite couche (28) de siliciure métallique réfractaire, en traversant ladite couche (30) de nitrure métallique réfractaire et en traversant ladite couche conductrice conforme, pour arriver à ladite couche (38) d'aluminium.

11. Stucture, dans un circuit intégré, pour relier un conducteur de silicium de premier niveau (10) et un conducteur métallique de second niveau (38) séparés par une couche (12) isolante, comprenant :
une ouverture (14) ayant des parois latérales (16, 18) sensiblement verticales, et traversant la couche isolante, dans laquelle une partie (19) du conducteur de premier niveau est exposée dans l'ouverture ;
des zones (22, 24) isolantes d'écartement de parois latérales, couvrant les parois latérales de l'ouverture, les zones d'écartement de parois latérales ayant une plus grande épaisseur à proximité immédiate du conducteur de silicium de premier niveau qu'au niveau d'une surface supérieure de la couche isolante ;
une couche (28) de siliciure métallique réfractaire couvrant la partie exposée du conducteur de silicium de premier niveau ;
une couche (30) de nitrure métallique réfractaire couvrant la couche de siliciure métallique réfractaire, les zones d'écartement de parois latérales et une partie de la surface supérieure de la couche isolante ; et
une couche (32) conductrice conforme contenant un métal réfractaire, couvrant la couche (30) de nitrure métallique réfractaire;
dans laquelle ledit conducteur métallique de second niveau comprend une couche d'aluminium couvrant la couche conductrice conforme.

12. Structure selon la revendication 11, dans laquelle la couche (32) conductrice conforme comprend un siliciure métallique réfractaire.

13. Structure selon la revendication 12, dans laquelle la couche (32) conductrice conforme comprend du disiliciure de tungstène.

14. Structure selon la revendication 12, dans laquelle la couche (32) conductrice conforme comprend du siliciure de titane.

15. Structure selon l'une quelconque des revendications 11 à 14, dans laquelle ladite couche (28) de siliciure métallique réfractaire comprend du siliciure de titane.

16. Structure selon l'une quelconque des revendications 11 à 15, dans laquelle ladite couche (30) de nitrure métallique réfractaire comprend du nitrure de titane.

17. Structure selon la revendication 11, dans laquelle le conducteur de second niveau (38) est susjacent à ladite couche (32) conductrice conforme située au-dessus de la couche (12) isolante, dans laquelle une connexion conductrice est faite à partir du conducteur de premier niveau, en traversant ladite couche (28) de siliciure métallique réfractaire, en traversant ladite couche (30) de nitrure métallique réfractaire et en traversant ladite couche conductrice conforme, jusqu'audit conducteur de second niveau.

18. Structure selon l'une des revendications 11 à 17, dans laquelle la couche (32) conductrice conforme comprenant un siliciure métallique réfractaire a une épaisseur sensiblement uniforme.
